# EUROPÄISCHE PATENTANMELDUNG

(11) **EP 4 665 089 A1**
(43) Veröffentlichungstag der Anmeldung: **17.12.2025**
(21) Anmeldenummer: 25181335.8
(22) Anmeldetag: 06.06.2025
(51) Int. Cl.: H05K 1/02, H02M 7/00, H05K 1/18, H05K 3/34, H05K 1/03, H05K 1/14

(54) **SCHALTUNGSANORDNUNG**

(30) Priorität: 14.06.2024 DE 102024205526
(71) Anmelder: VOLKSWAGEN AG, 38440 Wolfsburg (DE)
(72) Erfinder: Wilke, Robert, 38440 Wolfsburg (DE); Bayer, Christoph Friedrich, 38440 Wolfsburg (DE); Brüggemann, Marco, 38440 Wolfsburg (DE)

(57) **Zusammenfassung**

Die Erfindung betrifft eine Schaltungsanordnung (1), die ein Leistungsmodul (3) und mindestens einen Kondensator (2) aufweist, wobei das Leistungsmodul (3) mehrere Leistungstransistoren auf einem ersten Substrat aufweist, wobei der Kondensator (2) und die Leistungshalbleiter über mindestens eine erste elektrische Verbindung und mindestens eine zweite elektrische Verbindung miteinander verbunden sind, wobei die elektrischen Verbindungen mindestens teilweise durch ein weiteres Substrat gebildet sind, wobei das weitere Substrat als Leiterplatte (5) oder als Isoliertes-Metall-Substrat ausgebildet ist.

## Beschreibung

Die Erfindung betrifft eine Schaltungsanordnung, die ein Leistungsmodul und mindestens einen Kondensator aufweist.

Eine solche Schaltungsanordnung ist beispielsweise in einem Traktionsnetz eines Elektro- oder Hybridfahrzeugs vorhanden, wobei das Leistungsmodul ein Wechselrichter, insbesondere ein Pulswechselrichter, ist. Der Kondensator ist dann ein sogenannter Zwischenkreiskondensator. Der Kondensator und der Wechselrichter sind dann über eine erste elektrische Verbindung und eine weitere elektrische Verbindung miteinander verbunden, wobei an der ersten elektrischen Verbindung das positive Hochvoltpotential DC+ und an der zweiten elektrischen Verbindung das negative Hochvoltpotential DC- anliegt. Die Schaltverluste im Wechselrichter sind stark von der Kommutierungsinduktivität abhängig, also dem elektrischen Pfad zum Zwischenkreiskondensator. Daher wird eine niederinduktive elektrische Verbindung angestrebt.

Aus der CN 117412485 B ist eine Schaltungsanordnung mit Zwischenkreiskondensator und Leistungsmodul bekannt, die in einer sechslagigen Leiterplatten-Komponente integriert sind. Dieser sehr kompakte Aufbau ist fertigungstechnisch sehr komplex. Ein weiteres Problem ist die schlechte Wärmeabführung der Verlustleistung der Leistungstransistoren des Wechselrichters.

In den meisten Umsetzungen weist daher das Leistungsmodul ein eigenes Substrat auf (z.B. Cu/Keramik/Cu), auf dem die Leistungstransistoren angeordnet sind. Über die Keramik kann die Verlustleistung sehr gut abgeführt werden. Die elektrische Verbindung zum separaten Zwischenkreiskondensator erfolgt dann über Busbars (Stromschienen). Um die Induktivität klein zu halten, müssen diese dicht nebeneinander geführt werden, aber andererseits elektrisch voneinander isoliert bleiben. Daher ist es bekannt, die Busbars zu laminieren oder zu umspritzen, was jedoch wieder den Abstand vergrößert.

Der Erfindung liegt daher das technische Problem zugrunde, eine gattungsgemäße Schaltungsanordnung zu schaffen, bei der Kommutierungsinduktivität reduziert wird.

Die Lösung des technischen Problems ergibt sich durch eine Schaltungsanordnung mit den Merkmalen des Anspruchs 1. Weitere vorteilhafte Ausgestaltungen der Erfindung ergeben sich aus den Unteransprüchen.

Die Schaltungsanordnung weist ein Leistungsmodul und mindestens einen Kondensator auf. Weiter weist das Leistungsmodul mehrere Leistungstransistoren auf einem ersten Substrat auf. Der Kondensator und die Leistungshalbleiter sind über mindestens eine erste elektrische Verbindung und mindestens eine zweite elektrische Verbindung miteinander verbunden. Dabei sind die elektrischen Verbindungen mindestens teilweise durch ein weiteres Substrat gebildet, wobei das weitere Substrat als Leiterplatte oder als Isoliertes-Metall-Substrat (IMS) ausgebildet ist. Hierdurch lässt sich jeweils eine sehr enge (dicht beieinander liegende) Führung der elektrischen Verbindungen erreichen, sodass die Induktivität gering ist. Dabei wird insbesondere auf die ausgereifte Isolationstechnik bei mehrlagigen Leiterplatten zurückgegriffen. Das Substrat des Leistungsmoduls ist vorzugsweise als Cu-Keramik-Cu-Substrat ausgebildet.

Das Leistungsmodul ist vorzugsweise als Pulswechselrichter ausgebildet.

In einer weiteren Ausführungsform sind die elektrischen Verbindungen in unterschiedlichen Metallisierungsebenen der Leiterplatte ausgebildet. Somit kann nahezu die komplette Metallisierungsebene als elektrische Verbindung genutzt werden, was bezüglich Widerstand und Stromtragfähigkeit von Vorteil ist. Vorzugsweise ist die Dicke der Metallisierungsebene zwischen 140 - 210 µm (entspricht 4 -6 Unzen pro ft²), wobei die Metallisierungsebene vorzugsweise aus Kupfer ist. Alternativ kann die Leiterplatte auch in Dick-Kupfer-Technik hergestellt sein, wo Schichtdicken bis 400 µm realisiert sind. Bei einem IMS lassen sich Dicken von größer 400 µm realisieren.

In einer weiteren Ausführungsform weist die Leiterplatte mindestens vier Metallisierungsebenen auf, wobei die erste elektrische Verbindung und die zweite elektrische Verbindung jeweils mindestens zwei Metallisierungsebenen aufweisen. Hierdurch kann die Stromtragfähigkeit verbessert werden. Dabei sind die Metallisierungsebenen der ersten elektrischen Verbindung und der zweiten elektrischen Verbindung vorzugsweise alternierend übereinander angeordnet, sodass die Induktivität zu einer nicht alternierenden Anordnung reduziert ist.

In einer weiteren Ausführungsform sind die oberste Metallisierungsebene und die unterste Metallisierungsebene unkontaktiert oder mit einer Masseverbindung verbunden. Die oberste und unterste Metallisierungsebene wirken so als Schirmung für die ersten und zweiten elektrischen Verbindungen.

In einer weiteren Ausführungsform ist mindestens eine Metallisierungsebene mit mindestens einer Kontaktlasche ausgebildet. Dies vereinfacht eine direkte Kontaktierung der Leiterplatte mit dem Leistungsmodul, insbesondere mit den Leistungstransistoren.

In einer weiteren Ausführungsform sind mindestens eine Metallisierungsebene der ersten elektrischen Verbindungen und mindestens eine Metallisierungsebene der zweiten elektrischen Verbindung mit Kontaktlaschen strukturiert, wobei die Kontaktlaschen alternierend angeordnet sind, was die Induktivität reduziert.

In einer weiteren Ausführungsform ist das weitere Substrat direkt mit dem Leistungsmodul verbunden, z.B. verlötet, verschweißt oder gesintert.

In einer alternativen Ausführungsform ist das weitere Substrat über Pins bzw. Leadframes mit dem Leistungsmodul verbunden. Die Verbindung kann dabei durch Löten, Schweißen, Sintern, Pressen, Klemmen, Clinchen, Stecken oder Kleben erfolgen.

Die Erfindung wird nachfolgend anhand bevorzugter Ausführungsbeispiele näher erläutert. Die Figuren zeigen:
- Fig. 1: eine schematische Darstellung einer Schaltungsanordnung in einer ersten Ausführungsform,
- Fig. 2: eine schematische Darstellung einer Schaltungsanordnung in einer zweiten Ausführungsform,
- Fig. 3: eine schematische Darstellung einer Leiterplatte in einer dritten Ausführungsform,
- Fig. 4a: eine Darstellung von Metallisierungsebenen für eine erste elektrische Verbindung und eine zweite elektrische Verbindung und
- Fig. 4b: eine Darstellung von Metallisierungsebenen für eine erste elektrische Verbindung und eine zweite elektrische Verbindung in einer alternativen Ausführungsform.

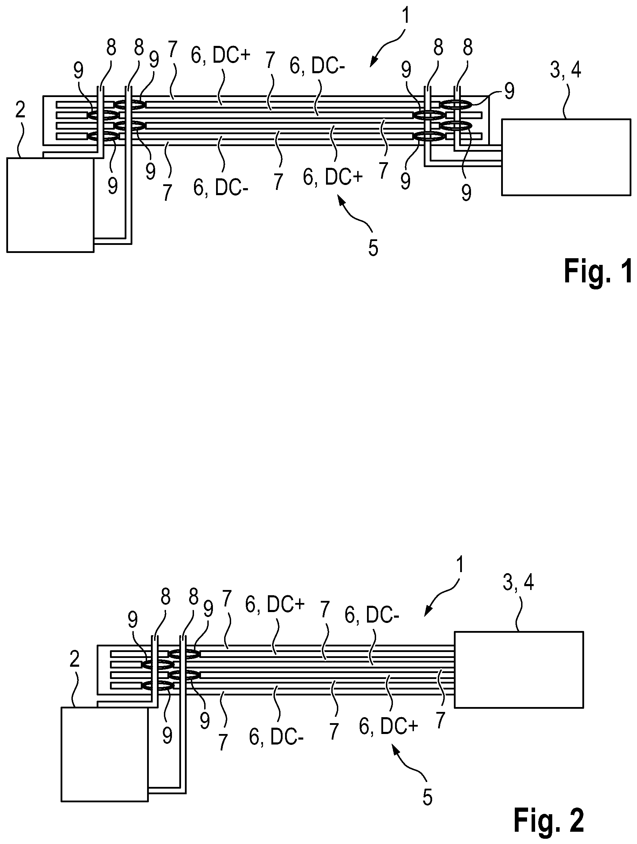

In der Fig. 1 ist stark schematisch eine Schaltungsanordnung 1 in einer ersten Ausführungsform dargestellt. Die Schaltungsanordnung 1 weist einen Kondensator 2 und ein Leistungsmodul 3 auf, wobei das Leistungsmodul 3 als Pulswechselrichter 4 ausgebildet ist. Das Leistungsmodul 3 weist ein Substrat auf, auf dem die Leistungstransistoren angeordnet sind. Die Leistungstransistoren sind dabei die High-Side- und Low-Side-Schalter des Pulswechselrichters, wobei die High-Side-Schalter mit dem positiven Potential DC+ und die Low-Side-Schalter mit dem negativen Potential DC- verbunden werden sollen. Zur Verbindung von Kondensator 2 und Leistungsmodul 3 ist eine Leiterplatte 5 vorgesehen, die vier Metallisierungsebenen 6 aufweist, zwischen denen jeweils Isolationslagen 7 angeordnet sind. Über Pins 8 sind der Kondensator 2 und das Leistungsmodul 3 mit der Leiterplatte 5 verbunden. Eine erste elektrische Verbindung für das positive Potential DC+ wird durch einen Pin 8 des Kondensators 2 und zwei Metallisierungsebenen 6 sowie einen Pin 8 des Leistungsmodul 3 gebildet. Entsprechend wird die zweite elektrische Verbindung für das negative Potential DCgebildet. Dabei sind die Metallisierungsebenen 6 für DC+ und DC- alternierend angeordnet. Dabei sind Aussparungen 9 in den Metallisierungsebenen 6 dargestellt, wo die Pins 8 durch die Metallisierungsebenen 6 durchgeführt werden können, ohne diese zu kontaktieren. Die Leiterplatte 5 kann dabei als mehrlagige klassische Leiterplatte oder als flexible Leiterplatte ausgebildet sein. Vorzugsweise ist dabei die Metallisierungsebene so dick wie möglich. Daher kann die Leiterplatte auch in Dickschicht-Kupfer-Technik hergestellt sein. Die Anzahl der Metallisierungsebenen 6 kann dabei auch größer als 4 sein, z.B. 6, 8 oder 12. Aufgrund der Tatsache, dass die Isolationslagen 7 sehr dünn sind, ist die resultierende Induktivität sehr klein.

In der Fig. 2 ist eine alternative Ausführungsform der Schaltungsanordnung 1 dargestellt, wobei der einzige Unterschied zur Ausführungsform gemäß Fig. 1 ist, dass die Pins 8 am Leistungsmodul 3 entfallen und die Leiterplatte 5 direkt mit den Leistungstransistoren verbunden wird, was später noch näher erläutert wird.

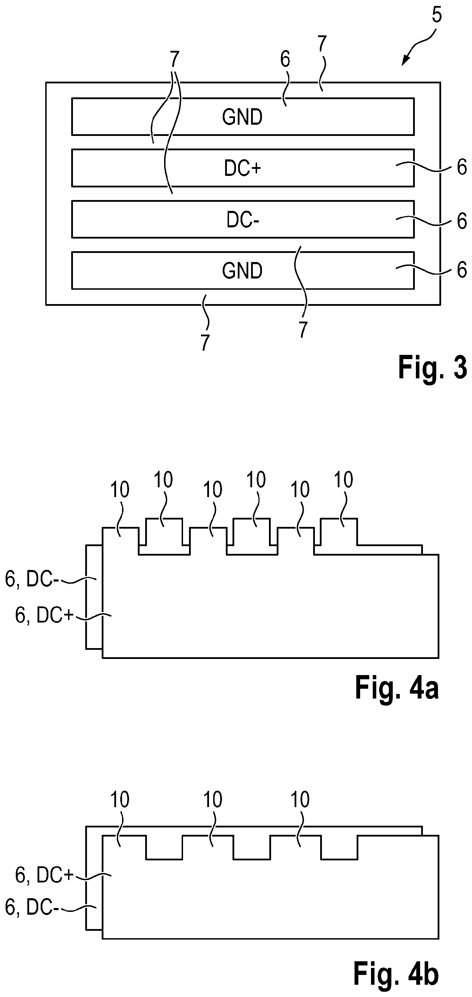

In der Fig. 3 ist eine weitere Ausführungsform dargestellt, wobei nur die Leiterplatte 5 im Querschnitt ohne die Aussparungen 9 dargestellt ist. Der Unterschied ist, dass die oberste und die unterste Metallisierungsebene 6 nicht für die erste und zweite elektrische Verbindung genutzt werden, sondern mit Masse GND verbunden sind oder unkontaktiert sind und so eine Schirmung bilden.

In Fig. 4a und Fig. 4b sind jeweils zwei Metallisierungsebenen 6 dargestellt, wobei die darüber, dazwischen und darunter liegenden Isolationslagen 7 nicht dargestellt sind (siehe Fig. 2). Dabei dient die eine Metallisierungsebene 6 zur Verbindung von DC+ und die andere für DC-. Dabei weisen die Metallisierungsebenen 6 gemäß Fig. 4a alternierend Kontaktlaschen 10 auf, mittels derer dann die Leistungstransistoren direkt kontaktiert werden. In Fig. 4b ist eine alternative Ausführungsform dargestellt, wobei die Kontaktlaschen 10 durch Aussparungen gebildet werden. Zur Kontaktierung werden dann die Isolationslagen 7 im Bereich der Kontaktlaschen 10 entfernt, sodass diese freiliegen. Die Ausgestaltung der Kontaktlaschen 10 hängt dabei entscheidend von der Anordnung der High-Side- und Low-Side-Schalter auf dem Substrat des Leistungsmoduls 3 ab.

### Bezugszeichenliste

- 1: Schaltungsanordnung
- 2: Kondensator
- 3: Leistungsmodul
- 4: Pulswechselrichter
- 5: Leiterplatte
- 6: Metallisierungsebene
- 7: Isolationslage
- 8: Pin
- 9: Aussparung
- 10: Kontaktlasche
- DC+: positives Potential
- DC-: negatives Potential
- GND: Masse

## Patentansprüche

1. Schaltungsanordnung (1), die ein Leistungsmodul (3) und mindestens einen Kondensator (2) aufweist, wobei das Leistungsmodul (3) mehrere Leistungstransistoren auf einem ersten Substrat aufweist, wobei der Kondensator (2) und die Leistungshalbleiter über mindestens eine erste elektrische Verbindung und mindestens eine zweite elektrische Verbindung miteinander verbunden sind,
**dadurch gekennzeichnet, dass**
die elektrischen Verbindungen mindestens teilweise durch ein weiteres Substrat gebildet sind, wobei das weitere Substrat als Leiterplatte (5) oder als Isoliertes-Metall-Substrat ausgebildet ist.

2. Schaltungsanordnung nach Anspruch 1, **dadurch gekennzeichnet, dass** das Leistungsmodul (3) als Pulswechselrichter (4) ausgebildet ist.

3. Schaltungsanordnung nach Anspruch 1 oder 2, **dadurch gekennzeichnet, dass** die elektrischen Verbindungen in unterschiedlichen Metallisierungsebenen (6) der Leiterplatte (5) ausgebildet sind.

4. Schaltungsanordnung nach Anspruch 3, **dadurch gekennzeichnet, dass** die Leiterplatte (5) mindestens vier Metallisierungsebenen (6) aufweist, wobei die erste elektrische Verbindung und die zweite elektrische Verbindung jeweils mindestens zwei Metallisierungsebenen (6) aufweisen.

5. Schaltungsanordnung nach Anspruch 4, **dadurch gekennzeichnet, dass** die Metallisierungsebenen (6) der ersten elektrischen Verbindung und der zweiten elektrischen Verbindung alternierend übereinander angeordnet sind.

6. Schaltungsanordnung nach Anspruch 4 oder 5, **dadurch gekennzeichnet, dass** die oberste Metallisierungsebene (6) und die unterste Metallisierungsebene (6) unkontaktiert oder mit einer Masse (GND) verbunden sind.

7. Schaltungsanordnung nach einem der Ansprüche 3 bis 6, **dadurch gekennzeichnet, dass** mindestens eine Metallisierungsebene (6) mit mindestens einer Kontaktlasche (10) strukturiert ist.

8. Schaltungsanordnung nach Anspruch 7, **dadurch gekennzeichnet, dass** mindestens eine Metallisierungsebene (6) der ersten elektrischen Verbindung und mindestens eine Metallisierungsebene (6) der zweiten elektrischen Verbindung mit Kontaktlaschen (10) strukturiert sind, wobei die Kontaktlaschen (10) alternierend angeordnet sind.

9. Schaltungsanordnung nach einem der vorangegangenen Ansprüche, **dadurch gekennzeichnet, dass** das weitere Substrat direkt mit dem Leistungsmodul (3) verbunden ist.

10. Schaltungsanordnung nach einem der Ansprüche 1 bis 8, **dadurch gekennzeichnet, dass** das weitere Substrat über Pins (8) mit dem Leistungsmodul (3) verbunden ist.
